# EUROPEAN PATENT APPLICATION

(11) **EP 3 240 106 A1**
(43) Date of publication of application: **01.11.2017**
(21) Application number: 17166876.7
(22) Date of filing: 18.04.2017
(51) Int. Cl.: H01Q 1/22, G01D 4/00, G01R 15/14, G08C 17/02, H01Q 1/38, H01Q 9/26, H01Q 1/44

(54) **ELECTRICAL ACTIVITY SENSOR DEVICE FOR DETECTING ELECTRICAL ACTIVITY AND ELECTRICAL ACTIVITY MONITORING APPARATUS**

(30) Priority: 25.04.2016 EP 16305484
(71) Applicant: Thomson Licensing, 92130 Issy-les-Moulineaux (FR)
(72) Inventor: LOUZIR, Ali, 35576 Cesson-Sévigné (FR); KUMAR, Rupesh, 35576 Cesson-Sévigné (FR); LE NAOUR, Jean-Yves, 35576 Cesson-Sévigné (FR)
(74) Representative: Barr, Angela Louise

(57) **Abstract**

An electrical activity sensor attachable to a power cable of an electrical device for detecting an impulse generated in the power cable in response to a change in electrical power state of the electrical device, the electrical activity sensor comprising an antenna assembly including
an antenna element operable to magnetically couple with an electrical pulse generated in the power cable, to induce an electrical signal, in response to a change in electrical power state of the electrical device and to wirelessly transmit data representative of the electrical power state change of the electrical device to a remote reader device; wherein
the antenna element is a helical shape dipole having at least one turn arranged, in use, around the power cable.

## Description

### TECHNICAL FIELD

The present disclosure relates to an electrical activity sensor device for detecting the electrical activity of an electrical device connected to a power supply network, particularly but not exclusively the change in electrical power state and to an electrical activity monitoring apparatus for monitoring the electrical activity of one or more electrical devices.

### BACKGROUND

The monitoring of electrical activity of electrical devices finds many useful applications in areas such as energy consumption, building user activity profiles, and security or safety monitoring systems. For example, in a home environment knowledge of the activity of electrical appliances such as washing machines, lighting devices; cookers, toaster or a coffee machine may provide useful information on the household habits and user activity enabling a profile to be built up.

A known solution for monitoring the activity of electrical devices employs a complex electrical meter system based on remote controlled modules plugged into power outlets and configured to measure the electrical consumption of the electrical equipment powered from the respective power outlet. Such, remote controlled modules are typical equipped with a wireless communication system generally based on low power wireless technology to remotely monitor and control the corresponding electrical appliance. Such advanced meter systems require however a complex and expensive customized installation. Indeed, a recent research report on home automation and monitoring indicated price and technical complexity as being the main market hurdles and inhibitors against widespread adoption. Another drawback of such techniques is that electrical devices may be moved from one power outlet to another power outlet. Moreover some devices such as lighting devices are not always powered from a power outlet.

Other solutions for the detection of the activity of electrical devices are based on sensing their "EMI (electromagnetic interference) signature" by monitoring the powerlines at one or several points of the power supply network. These techniques require however a customised calibration and training process to learn the EMI signature of various devices. Moreover the EMI signatures may evolve with time. Complex signal processing techniques are required to disaggregate the signatures of the various active devices connected to the network and the obtained results are not always very accurate.

Aspects of the present disclosure have been devised with the foregoing in mind.

### SUMMARY

In a general form the disclosure relates an electrical activity sensor device based on a helical dipole type antenna.
According to a first aspect of the invention there is provided an electrical activity sensor.attachable to cable for supplying power to an electrical device, said sensor being for detecting an impulse generated in the power cable in response to a change in electrical power state of the electrical device, the electrical activity sensor comprising an antenna assembly including
an antenna element operable to magnetically couple with an electrical pulse generated in the power cable, to induce an electrical signal, in response to a change in electrical power state of the electrical device and to wirelessly transmit data representative of the electrical power state change of the electrical device to a reader device; wherein the antenna element is a helical shape dipole having at least one turn arranged, in use, around the power cable
Detection of electrical activity can thus be provided in a simplified and low cost manner. The antenna element has a dual function of electrical activity detection and transmission of electrical activity data. The operational range of the electrical activity sensor device is extended since data is transmitted to an RFID reader via the helix dipole antenna. The use of the helical shape enables the reduction of the coupling to the wires inside the power cable at for example a UHF communication frequency and a reduction of the overall size of the antenna and to some extent, allows the optimization of the current impulse coupling
A change in the electrical power state of a device may include the switching ON of the device, the switching OFF of the device, the switching from a standby mode to an ON power state, and the switching from an ON power state to a standby mode. In an embodiment each turn of the antenna element is arranged, in use, orthogonal to wires of the power cable.

In an embodiment the antenna element is provided with a number of turns in the range from 3 to 7.

In an embodiment the antenna element is formed of 5 turns.

In an embodiment the spacing between turns is a distance in the range of 2 to 6 mm.

In an embodiment the spacing between adjacent turns is approximately 4mm.

In an embodiment the pitch angle of the turns is an angle in the range of 10 to 20°.

In an embodiment the pitch angle of the turns is 15°.

In an embodiment the length of one turn is in the range of 10mm to 20mm.

In an embodiment the length of one turn is 16mm.

A second aspect of the invention relates to an electrical activity monitoring apparatus for monitoring the electrical power status of at least one electrical device connected to a power supply network by a respective power cable and, the electrical activity monitoring apparatus comprising:
a reader module for reading data received wirelessly from at least one electrical activity sensor device attached to a respective power cable of an electrical device wherein the data is received from the electrical activity sensor device via wireless transmission from an antenna of the electrical activity sensor device and the data is representative of electrical power status change of the electrical device; and
a monitor device for determining from the data received by the reader module, which electrical devices of the network have changed electrical power status.

According to a further aspect of the invention there is provided an electrical activity monitoring system comprising at least one electrical activity sensor according to any embodiment of the first aspect of the invention for monitoring the electrical status of an electrical device, and an electrical activity monitoring apparatus according to any embodiment of the second aspect of the invention.

In an embodiment the electrical activity monitoring system further includes an electricity meter connected to the electrical activity monitoring apparatus for monitoring electrical power consumption in the power supply network.

In an embodiment the RFID reader module is configured to transmit interrogation signal to the RFID tag devices in response to a detected change in power consumption measured by the electricity meter.

In some embodiments of the invention timing means are provided to determine how long an electrical appliance has been switched ON or switched OFF.

According to a further aspect of the invention there is provided an antenna assembly attachable to a power cable of an electrical device for detecting an impulse generated in the power cable in response to a change in electrical power state of the electrical device, the an antenna assembly including a helical dipole-type, operable to magnetically couple with an electrical pulse generated in the power cable to induce an electrical signal in response to a change in electrical power state of the electrical device; and to wirelessly transmit data representative of the power state change of the electrical device from the antenna assembly to a remote RFID reader.

Another aspect of the invention relates to a method for detecting a change in electrical power state of an electrical device, comprising
an antenna element magnetically coupling with an electrical pulse generated in the power cable, to induce an electrical signal, in response to a change in electrical power state of the electrical device, said antenna element comprising a helical shape dipole having at least one turn arranged, in use, around the power cable
said antenna element wirelessly transmitting data representative of the electrical power state change of the electrical device to a reader device
Some processes implemented by elements of the invention may be computer implemented. Accordingly, such elements may take the form of an entirely hardware embodiment, an entirely software embodiment (including firmware, resident software, micro-code, etc.) or an embodiment combining software and hardware aspects that may all generally be referred to herein as a "circuit", "module" or "system'. Furthermore, such elements may take the form of a computer program product embodied in any tangible medium of expression having computer usable program code embodied in the medium.

Since elements of the present invention can be implemented in software, the present invention can be embodied as computer readable code for provision to a programmable apparatus on any suitable carrier medium. A tangible carrier medium may comprise a storage medium such as a floppy disk, a CD-ROM, a hard disk drive, a magnetic tape device or a solid state memory device and the like. A transient carrier medium may include a signal such as an electrical signal, an electronic signal, an optical signal, an acoustic signal, a magnetic signal or an electromagnetic signal, e.g. a microwave or RF signal.

### BRIEF DESCRIPTION OF THE DRAWINGS

Embodiments of the invention will now be described, by way of example only, and with reference to the following drawings in which:
FIG. 1 is a schematic block diagram of an electrical activity monitoring system in which one or more embodiments may be implemented
FIG. 2 is a schematic diagram of an electrical activity sensor device mounted on a power cable in accordance with a first embodiment;
FIG. 3 is a schematic diagram geometrically illustrating the electrical activity sensor device of FIG. 2;
FIG. 4A is a schematic diagram geometrically illustrating sizing parameters of an electrical activity sensor device in accordance with an embodiment;
FIG. 4B is a schematic diagram geometrically illustrating modeling of sizing parameters of FIG 4A;
FIG. 5A graphically illustrates an example of simulated antenna pattern in two orthogonal planes for an antenna assembly comprising a dipole type antenna element in the presence of a power cable;
FIG. 5B graphically illustrates an example of simulated antenna pattern in two orthogonal planes for an antenna assembly comprising a helical shaped dipole type antenna element in accordance with an embodiment;
FIG 6 geometrically illustrates flux of a magnetic field generated by an impulse current in the power cable in response to the change in electrical power state of an electrical device powered via the cable;
FIG. 7 is a schematic diagram of an electrical activity sensor device mounted on a power cable in accordance with an embodiment;
FIG. 8 is a schematic diagram of an electrical activity sensor device prior to being mounted on a power cable in accordance with an embodiment;
FIG. 9 is a schematic diagram of an electrical activity sensor device mounted on a power cable in accordance with another embodiment;
FIG. 10A is a block functional diagram of elements of an electrical activity sensor device in accordance with an embodiment;
FIG. 10B is a graphical diagram illustrating a signal processing process implemented by an electrical activity sensor in accordance with an embodiment; and
FIG. 11 is a schematic block diagram of an electrical activity monitoring apparatus in accordance with an embodiment.

### DETAILED DESCRIPTION

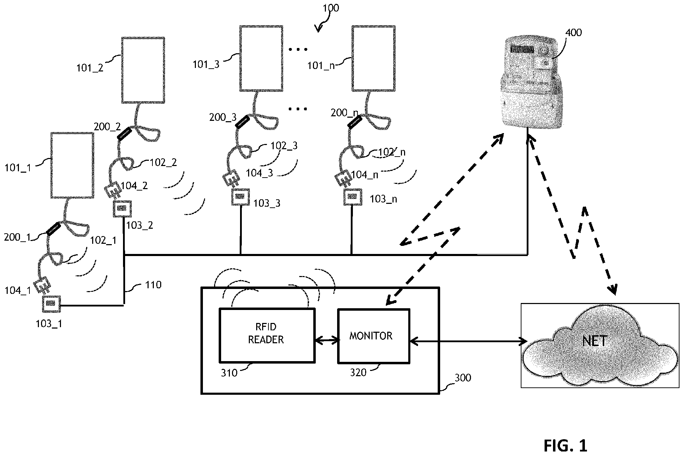

Figure 1 is a schematic block diagram of an electrical activity monitoring system in which one or more embodiments may be implemented. The electrical activity monitoring system 100 monitors the change in electrical status of n electrical devices 101_1 to 101_n. Each electrical device 101_1 to 101_n is connected by means of a respective electrical power cable 102_1 to 102_n to a power outlet 103_1 to 103_n of an electrical power supply network 110. It will be appreciated that while in the illustrated embodiment of Figure 1 each electrical device 101_1 to 101_n is connected to a respective power outlet 103_1 to 103_n, in other embodiments of the invention a plurality of electrical devices may be connected to the same power outlet 103_x.

Each electrical power cable 102_1 to 102_n is provided with a respective plug 104_1 to 104_n for connecting the respective electrical power cable to a respective power outlet 103_1 to 103_n for connection to the power supply network 110.

Each electrical power cable 102_1 to 102_n is further provided with a respective electrical activity sensor 200_1 to 200_n. Each electrical activity sensor 200_1 to 200_n is attached to a respective power cable 102_1 to 102_n. The electrical activity sensor 200_1 to 200_n comprises an antenna assembly.

The electrical activity monitoring system 100 further includes an electrical activity monitoring apparatus 300. The power supply network 110 is typically provided with an electricity meter 400 for measuring electrical consumption in the power supply network 110. The electrical activity monitoring apparatus 300 may be connected to a communication network NET such as an Internet network so that data on the electrical activity of the system may be transmitted to a remote device, such as a remote electrical activity monitoring device for example the server of a remote an electrical activity monitoring service or an electricity power supplier company.

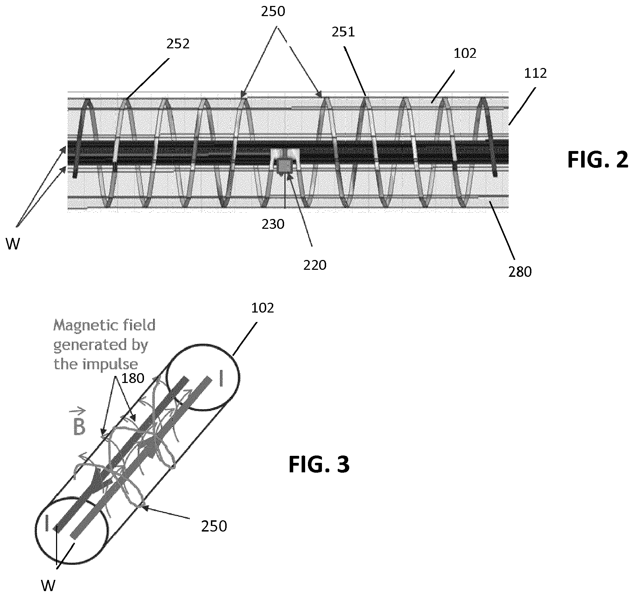

Figure 2 schematically illustrates an electrical activity sensor in accordance with an embodiment. The electrical activity sensor 200 comprises an antenna assembly including a helical shaped dipole type antenna 250 provided on a flexible substrate 280, and an RFID 220 circuit also provided on the flexible substrate 280. The antenna assembly may, for example be etched on the flexible support layer 280. The flexible support layer 280 may be provided with an adhesive surface for attachment to the power cable, for example, the flexible support layer may be, for example, a thin Polystyrene adhesive film.

In embodiments of the antenna the helical shaped dipole antenna may be provided in two parts arranged along the axis of the power cable 102 as illustrated in Figure 2 with a first helix part 251 wound in an opposite direction (the sense of wrapping could be either same or opposite) to a second helix part 252. The RFID circuits located between the two parts.

The RFID circuit 220 is provided with a memory chip 230 for storing data representative of electrical activity of the electrical device 101 and/or identification data identifying the electrical activity sensor. Each RFID circuit 220 in the electrical monitoring system 100 is provided with an identification code enabling it to be identified by the monitoring device 300. In some embodiments of the invention, the RFID circuit 220 is provided with a pulse detection module configured to detect the electrical pulse generated in the power cable 102_x when the electrical power state of the corresponding electrical device 102_1 changes.

The power cable 102_x comprises an insulating sheath 112 enclosing a plurality of conducting wires W for providing power from the power supply network 110 to the corresponding electrical device 101_x. The flexible substrate 280 is wrapped at least partially around the power cable 102_x and adheres by means of adhesive to the insulating sheath 112.

The use of the helical shape of antenna element 250 allows the reduction of the coupling to the wires inside the power cable at for example a UHF communication frequency, a reduction of the overall size of the antenna and an optimization of the coupling to the switch ON/OFF impulse. The helical shaped dipole type antenna 250 has a dual function. Firstly, the helical shaped dipole type antenna 250 is used to detect the electrical pulse generated in the respective power cable 102_*x* when the corresponding electrical device 101_*x* undergoes a change in electrical power state, for example is switched ON or switched OFF. Indeed, the generated electrical pulse results from the change in power state of the respective electrical device 101_x. When an electrical device 101_*x* is switched ON or OFF, a current pulse flows in its respective power cable 102_*x*. The helical shaped dipole type antenna 250 of the respective electrical activity device 200_x attached to the power cable 102_x couples magnetically to the current pulse by means of the flux of the magnetic field generated by the impulse through the surface generated by the helix. This generates an electrical pulse which can be detected by the pulse detection module 225. Data indicative of the electric state change is stored in the RFID circuit memory chip 230.

The second function of the helical shaped dipole antenna element 250 is to transmit data from the RFID circuit memory chip to a RFID reader of the electrical activity monitoring apparatus 300.

Figure 3 geometrically illustrates the helical shaped dipole antenna element arranged around the power cable 102_x and the magnetic field 180, to which the antenna element couples, which is generated by the electrical impulse in the power cable 102 resulting from the change in electrical state of the respective electrical device 101.

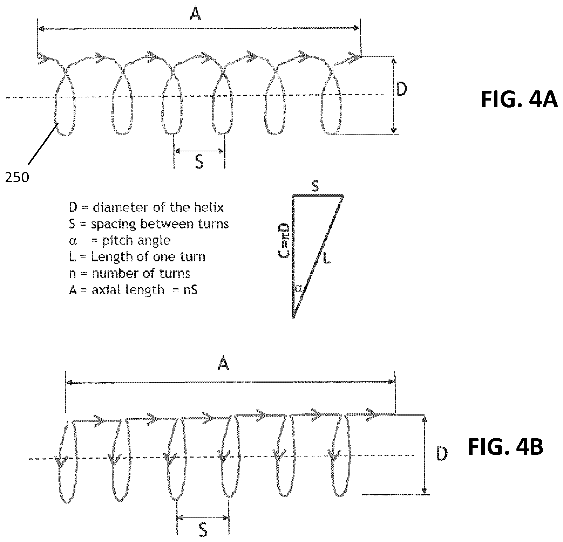

Figure 4A schematically illustrates a helical shaped dipole antenna 250 and its sizing parameters and Figure 4B schematically illustrates a possible modeling where each turn of length L of the helix of the helical shaped dipole antenna 250 , is replaced by a straight line of length S parallel to the helix axis followed by a loop of diameter D orthogonal to the axis. When wrapped around the power cable 102 because the loop is orthogonal to the cable wires W, the coupling is almost equal to 0. Therefore, only the straight parts of the helix model participate in the coupling of the antenna element 250 to the wires W of the power cable 102 limiting the disturbance by the power cable 102.

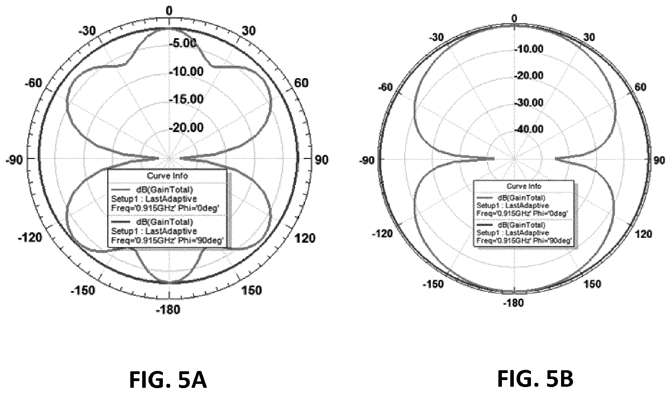

Figure 5A and 5B graphically illustrate 2 cuts of simulated 3D radiation patterns for a straight dipole antenna element and a helical shaped antenna element respectively confirming the lower coupling to the power cable, of the helical shaped antenna element. Indeed, the toroid shaped radiation pattern of a classical dipole with the helix is obtained (i.e. no extraneous radiation from the power cable)

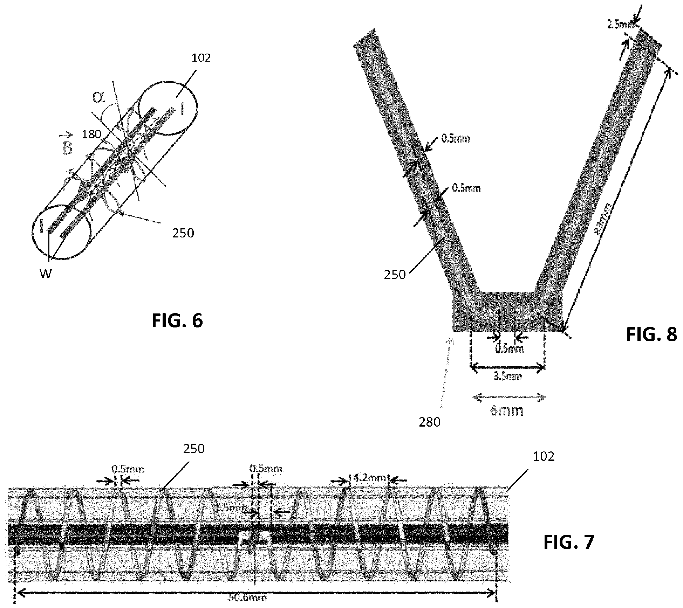

The coupling of the impulse generated in the power cable 102 to the helical antenna 250 obeys to the Faraday's Law of induction. With reference to Figure 6, the flux of the magnetic field generated by the impulse current in the power cable 102 in response to a change in electrical state of the corresponding electrical device 101 , through the helix surface depends on the helix pitch angle α and the number of turns in the helical antenna element 250. Therefore for α close to 0, the B field is almost perpendicular to the loop vector surface and the flux is almost 0. Increasing the pitch angle α enables an increase of the coupling to the impulse at the expense of increased axial length of the helix and increased coupling of the helical antenna to the power cable wires. Therefore a trade-off may be found for maximizing the impulse coupling while minimizing the antenna axial size and its coupling to the power cable 102.

Figure 7 schematically illustrates an example of an optimized design of a helical shaped dipole antenna element 250 provided on flexible substrate 280 with the following sizing:
- Diameter (D): 5 mm
- Spacing between turns (S): 4.2 mm
- Pitch Angle (α): 15°
- Length of one turn (L): 15.7 mm
- Number of turns (n): 5
- Axial Length (nS): 50.6 mm

In some embodiments of the invention for practical implementation of the antenna using a Printed Circuit Board (PCB) technology well suited for mass production with integrated components, a flat version of a helical shaped dipole antenna may be on flexible substrate with adhesive in the back side to be wrapped around the power cable is shown in Figure 8. The total length of each half dipole is calculated according to the sizing parameters illustrated in Figure 4.

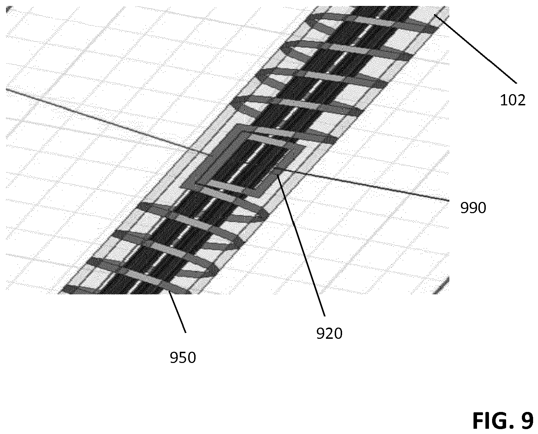

In another embodiment of the antenna as illustrated in Figure 9 the antenna assembly comprises a helical shaped dipole antenna 950 in accordance with any previous embodiment of the invention and a loop antenna element 990 for coupling to the electrical impulse generated in the power cable. In this embodiment the loop antenna element 990 detects the electrical pulse generated in the respective power cable 102_x when the corresponding electrical device undergoes a change in electrical power state and electromagnetically couples to the helical shaped dipole antenna element 950. The RFID circuit 920 is located at the loop antenna element 990/

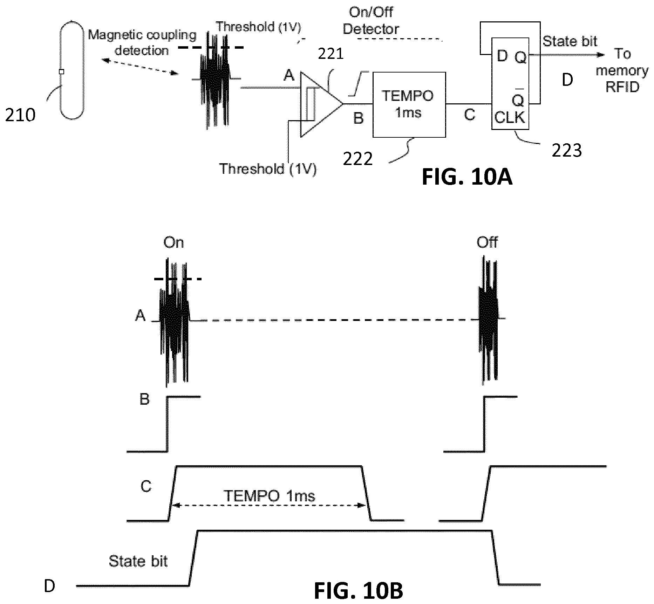

Figure 10A is a schematic diagram illustrating an example of operation of the pulse detection module 220 of an electrical activity sensor 201. When the electrical power state of an electrical device changes, for example by being switched ON or OFF a corresponding power state change pulse signal A is picked up by the helical shaped antenna element 250, by means of a magnetic coupling effect. When the amplitude of the power state change pulse signal A exceeds a predetermined threshold (1 V for example), a block comparator 221 detects an input pulse signal and in response changes the state of the output signal B. In order to avoid multi triggering, a temporization device 222 may be connected to the output of the comparator 221 to provide a signal C at its output which corresponds to the signal issued from the comparator during a set temporization time. A D flip flop module 223 generates a state bit D. The state bit D is changed for each clocked impulse since the D Flip Flop module 223 is clocked by the output signal C of the temporization module 222. Consequently, the last bit of bit signal D changes state at each detected pulse (at switch on or off). The state can thus be used to indicate an electrical power state change. The bit value is stored in the memory chip 230 of the RFID sensor device 201. This information representative of a change of electrical power state of respective electrical device 101_x can then be transmitted with the identification code ID of the electrical activity sensor device 200 to the monitoring device 300 by the antenna assembly 200. An example of signals A, B, C and D of the operation of Figure 10A are graphically represented in Figure 10B

In particular embodiments of the invention by knowing the initial electrical power state of the electrical device 101_x at counter reset, it is possible to determine from the state of bit signal D whether the electrical change corresponds to an ON/OFF electrical status change or an OFF/ON electrical status change. Moreover, by knowing the ON or OFF power state of the electrical device at the previous reading the ON or OFF power state at the subsequent reading can be deduced.

When activated by an electrical power state change, the radiating helical shaped antenna element wirelessly transfers data indicative of an electrical state change from the memory chip 230 to the RFID reader 310 of the monitoring device 300.

Data representative of the electrical state change may be transferred by the electrical activity sensor 200 to the RFI D reader 310, for example at each interrogation by the RFID reader operating in the RFID frequency band.

The electrical activity sensor 200 may be attached to the respective power cable 102_*x* by any form of fixation means such as for example by adhesive such as glue, sticking tape, or a sticker, by a mechanical connection such as for example staples, screws, nails; or by being embedded in the insulating sheath cover 112 of the respective power cable 102_x.

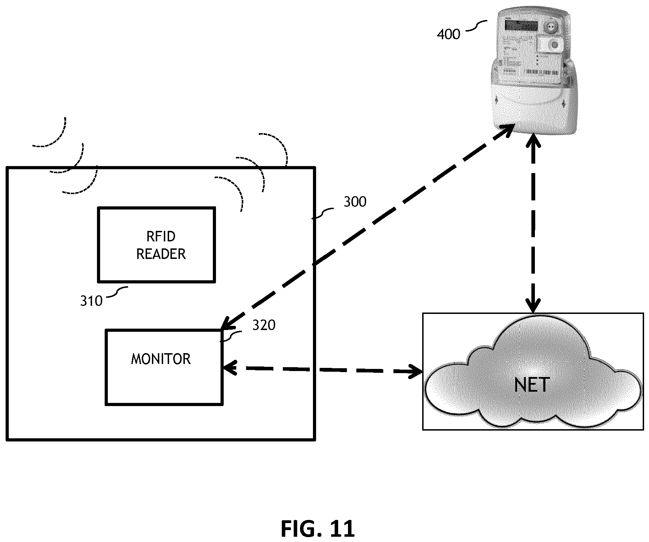

Figure 11 is a block diagram schematically illustrating an electrical activity monitoring apparatus 300 in accordance with an embodiment of the invention. The electrical activity monitoring apparatus 300 comprises an RFID reader device 310 and a monitoring device 320 for processing RFID data signals.

The RFID reader device 310 is a far field RFID type reader and is configured to wirelessly receive RFID data signals transmitted from the electrical activity sensors attached to the power cables 102 of the network via wireless transmission from the respective dipole type antenna 250 and to send RFID interrogation signals to the RFID sensors 200 via wireless transmission to the respective dipole type antennas 250.

Monitoring device 320 receives data from the RFID reader device 310 indicative of the electrical activity status of the electrical devices 101_1 to 101_n in the electrical activity monitoring system 100.

In one particular embodiment of the invention the monitoring device 320 is connected to a smart type electricity meter 400 connected to the power supply network 110 of the system. The electricity meter 400 and the monitoring 320 device may be connected by a wireless or wired connection. The smart electricity meter 400 is configured to monitor the power consumption of electrical devices 101_1 to 101_n connected to the power network 110. The smart electricity meter 400 is configured to detect a change in power consumption: for example an increase in the rate of power consumption which may result from the switching ON of one or more electrical devices 101_1 to 101_n supplied by the power network 110, or a decrease in the rate of power consumption which may result from the switching OFF or to STANDBY of one or more of the electrical devices 101_1 to 101_n supplied by the power network 110. In response to the detected change in power consumption a command signal is transmitted from the monitoring device 320 to the RFID reader device 310 to activate an RFID reading process. The RFID reader device 310 in response to the command signal transmits an interrogation signal to the electrical activity sensor devices 201_1 to 201_n in order to read the electrical status data stored in the respective RFID memory chips 230_1 to 230_n of the electrical activity sensor devices 201_1 to 201_n. The interrogation signal to be sent from the RFID reader 310 to one or more electrical activity sensors 200s by wireless transmission. Response signals are then transmitted by the electrical activity sensors 200_1 to 200_n towards the monitoring apparatus 300 by means of the respective helical shaped dipole type antennas 250. The response signals from the electrical activity sensor devices 200_1 to 200_n each include the identification code of the respective electrical devices 102_1 to 102_n and the corresponding electrical power state change information stored in the respective RFID memory chip 230. The collected electrical power state change information signals are received and read by the RFID reader device 310. The processed electrical power state change activity information is then transmitted to the monitoring device 320.

Monitoring device 310 may further process the received power state change information or transfer the power state change information to another device, such as a remote device connected via a communication network.

For example, if an electrical device 101_x, for example a coffee machine, connected to a household power supply network 110 is switched ON (for example from an OFF power state or from a STANDBY mode):
1. The total power consumption will increase by an amount corresponding to the power consumed by the coffee machine. This change in power consumption will be measured by smart electricity meter 400.
2. The current impulse generated in the corresponding power cable in response to the switch on activates the corresponding electrical activity sensor device 201 attached to the respective power cable, and the status information change (OFF to ON) is stored in the RFID memory chip by switching a bit (the "state bit") from 0 (corresponding to OFF state) to 1 (corresponding to ON state)

The increase in power consumption measured by the smart electricity meter 400 may be detected by the monitoring device 320. In response to the detected increase a read command is sent to the RFID reader device 300 to trigger a read phase of the RFID reader device 310. The RFID reader module 310 reads all the electrical activity sensor devices 201_1 to 201_n of the electrical devices 101_1 to 101_n connected to the power network 110 by transmitting interrogation signals. The read information of each electrical activity sensor 201_1 and includes its identification and its electrical ON/OFF change status.

In some embodiments by comparing the electrical change status of all the electrical activity sensor devices read with the previous one stored in an electrical devices status dataset, at the previous reading phase, it is possible to infer which electrical device has been powered on and the electrical devices status dataset may be updated accordingly.

In other embodiments, the state of the respective state bit signal stored on the corresponding RFID memory chip can be used to identify which electrical device or devices have been switched on or off.

In some particular embodiments of an electrical device an electrical pulse generated by an ON to OFF or STANDBY electrical power state change, may be distinguished from an electrical pulse generated by an OFF or STANDBY to ON electrical power state change by characterizing the pulse signals. The impulse detector 220 of the RIFD sensor device 201 of such embodiments is configured to detect from the characteristics of the generated electrical pulse signal whether the electrical pulse results from an ON to OFF or STANDBY power state change or from an OFF or STANDBY to ON power state change.

In further embodiments, the impulse detector may be configured to distinguish between an OFF to ON and a STANDBY to ON; and to distinguish between an ON to STANDBY and an ON to OFF, by characterizing the resulting pulse signals.

In another embodiment, the power consumed by an electrical device 101_x may be determined, for example by detecting an OFF to ON power state change or a standby to ON power state change and then determining the duration of time for which the electrical device is placed in an ON state. Data representative of the power consumption may then be transferred from the corresponding electrical activity sensor device 200_x to the RFID reader device 300 by the antenna assembly in the same way as data representative of the electrical power state change is transmitted to the RFID reader device 300.

The electrical power state change data or consumption data may be processed to provide relevant information on electrical activity of the power network 110, such as for example to build a household user profile, to detect and warn of increased electrical power consumption, and/or to provide recommendations for reducing energy consumption

In other embodiments, rather than sending an interrogation signal from the RFID reader to the electrical activity sensor devices in response to a command from the monitoring device 320 the RFID reader may send interrogation signals automatically to the electrical activity sensor devices without being commanded by the monitoring device; for example on a periodic basis.

In some embodiments of the system that monitoring device may be part of a home gateway system connected to an external internet network. Real time tracking of the total home power consumption could be provided by the home electricity provider via the internet network. For example the electricity provider could trigger reading phases of the RFID reader by transmitting signals from a remote server via the gateway device.

Although the present disclosure has been presented hereinabove with reference to specific embodiments, it is not limited to the specific embodiments, and modifications will be apparent to a skilled person in the art which lie within the scope of the disclosure.

For instance, while the foregoing examples have been described with respect to a household power network system, it will be appreciated that embodiments may be applied to any power network to which electrical devices are connected. Moreover the system could be applied in security or safety applications to identify electrical devices which have been switched on or switched off.

Many further modifications and variations will suggest themselves to those versed in the art upon making reference to the foregoing illustrative embodiments, which are given by way of example only and which are not intended to limit the scope of the invention, that being determined solely by the appended claims. In particular the different features from different embodiments may be interchanged, where appropriate.

## Claims

1. An electrical activity sensor attachable to cable for supplying power to an electrical device, said sensor being for detecting an impulse generated in the power cable in response to a change in electrical power state of the electrical device, the electrical activity sensor comprising an antenna assembly including
an antenna element operable to magnetically couple with an electrical pulse generated in the power cable, to induce an electrical signal, in response to a change in electrical power state of the electrical device and to wirelessly transmit data representative of the electrical power state change of the electrical device to a reader device; wherein
the antenna element is a helical shape dipole having at least one turn arranged, in use, around the power cable

2. An electrical activity sensor according to claim 1 wherein each turn of the antenna element is arranged, in use, orthogonal to wires of the power cable.

3. An electrical activity sensor according to claim 1 or 2 wherein the antenna element is provided with a number of turns in the range from 3 to 7.

4. An electrical activity sensor according to claim 3 wherein the antenna element is formed of 5 turns.

5. An electrical activity sensor according to any preceding claim wherein the spacing between turns is a distance in the range of 2 to 6 mm.

6. An electrical activity sensor according to claim 5 wherein the spacing between adjacent turns is approximately 4mm.

7. An electrical activity sensor according to any preceding claim wherein the pitch angle of the turns is an angle in the range of 10 to 20°.

8. An electrical activity sensor according to claim 5 wherein the pitch angle of the turns is 15°.

9. An electrical activity sensor according to any preceding claim wherein the length of one turn is in the range of 10mm to 20mm.

10. An electrical activity sensor according to claim 5 wherein the length of one turn is 16mm.

11. An electrical activity monitoring apparatus for monitoring the electrical power status of at least one electrical device connected to a power supply network by a respective power cable and, the electrical activity monitoring apparatus comprising:
a reader module for reading data received wirelessly from at least one electrical activity sensor device attached to a respective power cable of an electrical device wherein the data is received from the electrical activity sensor device via wireless transmission from an antenna of the electrical activity sensor device and the data is representative of electrical power status change of the electrical device; and
a monitor device for determining from the data received by the reader module, which electrical devices of the network have changed electrical power status.

12. An electrical activity monitoring system comprising
at least one electrical activity sensor according to any one of claims 1 to 10, and
an electrical activity monitoring apparatus according to claim 11.

13. A method for detecting a change in electrical power state of an electrical device, comprising
an antenna element magnetically coupling with an electrical pulse generated in the power cable, to induce an electrical signal, in response to a change in electrical power state of the electrical device, said antenna element comprising a helical shape dipole having at least one turn arranged, in use, around the power cable
said antenna element wirelessly transmitting data representative of the electrical power state change of the electrical device to a reader device.

14. A method according to claim 13 wherein each turn of the antenna element is arranged, in use, orthogonal to wires of the power cable

15. A non-transitory computer readable storage medium having stored thereon instructions for implementing a method according to claim 13 or 14.
